Europäisches Patentamt

European Patent Office

Office européen des brevets

(19)

(11) Numéro de publication: **0 002 421**
**B1**

(12) **FASCICULE DE BREVET EUROPEEN**

(45) Date de publication du fascicule de brevet: **25.11.81**

(51) Int. Cl.³: **H 01 L 21/326**

(21) Numéro de dépôt: **78430013.9**

(22) Date de dépôt: **04.10.78**

(54) Procédé de neutralisation des charges positives contenues dans l'isolant de porte d'au moins un transistor à effet de champ à porte isolée.

(30) Priorité: **25.11.77 US 854563**

(43) Date de publication de la demande:
**13.06.79 Bulletin 79/12**

(45) Mention de la délivrance du brevet:
**25.11.81 Bulletin 81/47**

(84) Etats Contractants Désignés:
**DE FR GB**

(56) Documents cités:
**DE - A - 2 530 730**
**DE - B - 1 614 146**
**US - A - 3 925 107**

**IBM Technical Disclosure Bulletin; Vol. 17, n° 4,**
**September 1974**
**Armonk, N.Y., USA,**
**A. HORNUNG et al. "Removal of charge in the**
**gate region of a fet" pages 1042 à 1043.**

(73) Titulaire: **International Business Machines Corporation**
**Armonk, N.Y. 10504 (US)**

(72) Inventeur: **Ning Tak, Hung**
**1720 Maxwell Drive**
**Yorktown Heights New York 10598 (US)**
Inventeur: **Osburn, Carlton Morris**
**41 Morningside Drive**
**Croton-on-Hudson New York 10520 (US)**
Inventeur: **Yu Hwa, Nien**
**2849 Hickory Street**
**Yorktown Heights New York 10598 (US)**

(74) Mandataire: **Klein, Daniel**
**COMPAGNIE IBM FRANCE Département de Propriété Industrielle**
**F-06610 La Gaude (FR)**

Courier Press, Leamington Spa, England.

## Procédé de neutralisation des charges positives contenues dans l'isolant de porte d'au moins un transistor à effet de champ à porte isolée

Domaine technique

La présente invention concerne un procédé permettant de neutraliser les charges positives présentes dans l'isolant de porte d'au moins un transistor à effet de champ à porte isolée formé dans un substrat semi-conducteur (connu dans la littérature anglo-saxonne sous l'appellation d'"IGFET" et qui sera utilisée ci-après), plus particulièrement quand ce transistor fait partie d'un ensemble de transistors intégrés dans une même tranche semi-conductrice. Ce procédé comporte la génération d'électrons de conduction dans le substrat par un faisceau de radiations électromagnétiques.

Etat de la technique antérieure

Lors de la fabrication de dispositifs de ce type diverses étapes qui nécessitent l'application de chaleur et/ou d'énergie, notamment les étapes de diffusion, d'implantation ionique et d'irradation de matériau photorésistant, se traduisent par l'introduction de charges positives qui sont piégées dans l'oxyde constituant la porte de ces dispositifs. La présence de ces charges positives entraîne un décalage négatif de la tension de seuil qui est nécessaire pour provoquer le passage du courant dans ces dispositifs. Ce phénomène a jusqu'à présent contrarié la réalisation de dispositifs présentant des charges uniformes. Selon le procédé décrit dans le brevet US—A 3 580 745, l'application de chaleur et d'une lumière ultraviolette sont utilisées pour commander les charges présentes dans l'oxyde, une telle charge étant choisie pour permettre la réalisation de dispositifs présentant des caractéristiques spécifiques et pour assurer la compensation désirée dans le substrat. Un autre procédé, décrit dans le brevet FR—A 1 460 627 déposé par la demanderesse le 12 août 1965, préconise l'emploi de chaleur et d'une polarisation pour commander les performances des transistors à effet de champ. Dans ces deux derniers procédés, c'est au début du processus de fabrication que l'on cherche à commander les charges positives qui apparaissent dans l'oxyde, alors qu'en fait presque toutes les étapes de ce processus sont susceptibles d'introduire au moins quelques charges qui entraînent des variations dans les caractéristiques de conduction des différents dispositifs terminés. En fin il est connu du brevet DE—B—1 614 146 un procédé d'élimination des charges positives contenues dans l'isolant de porte d'un transistor à effet de champ à porte isolée, dans lequel le substrat et l'isolant sont chauffés et exposés à un champ électrique pour faire se déplacer les charges positives à la surface de l'isolant de porte.

Exposé de l'invention

La présente invention se rapporte à un procédé de neutralisation des charges positives dans l'isolant de porte d'un IGFET. Le procédé selon l'invention est caractérisé en ce que le faisceau de radiations électromagnétiques est appliqué sur la face arrière du substrat et que les électrons sont injectés depuis le substrat dans l'isolant de porte par application simultanée d'un champ électrique.

Elle est mise en oeuvre à l'une des dernières étapes de métallisation, celle dont le but est d'interconnecter toutes les portes et tous les drains des dispositifs avant l'étape de délimitation des configurations particulières d'interconnexion. Cette étape de métallisation permet d'obtenir une unique électrode. Simultanément à l'application d'une tension entre cette électrode et la face arrière du substrat semi-conducteur qui crée un champ électrique à l'interface substrat-isolant de porte, on procède à l'irradiation du substrat, au moyen d'une source de radiations électromagnétiques (une lumière ultra-violette par exemple), sur sa face arrière. Cette irradiation génère des électrons qui sont injectés dans l'isolant (généralement de l'oxyde) depuis ce substrat sous l'action du champ électrique. Ce procédé neutralise ainsi les charges positives et permet d'obtenir des dispositifs présentant tous, les mêmes caractéristiques de tension de seuil. Le procédé est particulièrement intéressant dans le cas d'un ensemble de transistors intégrés dans une même tranche semi-conductrice.

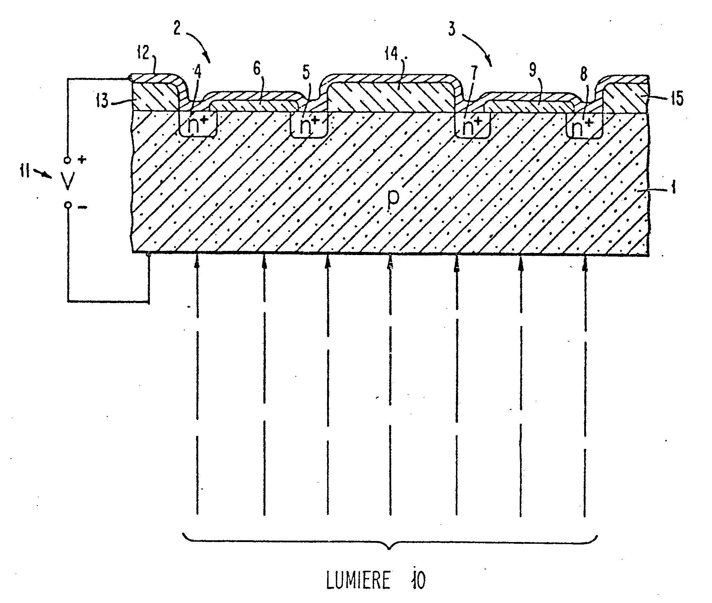

D'autres objets, caractéristiques et avantages de la présente invention ressortiront mieux de l'exposé qui suit, fait en référence au dessin annexé à ce texte, qui représente un mode de réalisation préféré de celle-ci.

La figure unique représente une coupe schématique d'une structure de transistors du type IGFET subissant une irradiation destinée à neutraliser les charges positives présentes dans l'oxyde qui constitue l'isolant de porte.

Description d'un mode de réalisation

Des charges positives sont toujours présentes dans l'oxyde d'un dispositif du type IGFET. La concentration de ces charges varie entre une valeur inférieure à $10^{10}/cm^2$ et une valeur supérieure à $10^{12}/cm^2$, selon le procédé de fabrication particulier que l'on utilise. Les charges positives présentes dans l'oxyde sont des pièges à électrons qui présentent la plus grande section de capture connue. La présence de ces charges pose donc un problème potentiel de fiabilité qui résulte du fait que les électrons chauds sont captés par ces pièges présents dans la porte isolée.

Chacune des étapes du procédé de fabrication, est susceptible d'introduire des charges positives dans l'oxyde de porte d'un dispositif IGFET. Etant donné que l'introduction de telles charges résulte d'événements aléatoires, il en résulte une variation de la tension de seuil des différents dispositifs réalisés, qui nuit à l'obtention de dispositifs présentant des caractéristiques uniformes. On sait qu'en effet la présence de ces charges positives dans l'isolant de porte provoque un décalage négatif de la tension de seuil du dispositif.

Dans un but de clarté, la présente invention sera décrite ci-après dans le contexte d'une tranche de silicium et d'une porte isolée en dioxyde de silicium. Il sera toutefois évident pour l'homme de l'art que les principes de la présente invention, ne sont pas limités à ce type particulier de dispositif à semi-conducteur.

On a représenté sur la figure unique un substrat 1 de conductivité de type p dans lequel, à titre d'exemple, se trouvent deux transistors du type IGFET respectivement désignés 2 et 3. L'IGFET 2 comporte une région de source 4 du type $n^+$ et une région de drain 5 du type $n^+$ également. Une porte isolée 6 en oxyde de silicium est prévue sur la région de canal qui se trouve dans le substrat 1 entre les régions 4 et 5. De même, l'IGFET 3 possède une région de source 7, une région de drain 8 et une porte 9 en oxyde au-dessus de la région de canal définie entre les régions 7 et 8.

En cours de fabrication, les nombreuses étapes qui introduisent des contraintes résultant de l'application de chaleur et d'énergie, de même que les radiations employées aux fins de l'exposition de divers matériaux photorésistants, provoquent l'apparition et le piégeage de charges positives dans les couches d'oxyde 6 et 9 qui constituent les isolants des portes des dispositifs IGFET 2 et 3. Ces charges positives variant d'un dispositif à l'autre, il s'ensuit que les caractéristiques de seuil des différents dispositifs varient également. Conformément à la présente invention, les charges positives contenues dans les couches d'oxyde 6 et 9 peuvent être neutralisées en exposant la face arrière du substrat 1 à une source de radiation telle que la lumière tout en appliquant une tension entre le substrat et l'oxyde de porte; des électrons sont ainsi injectés depuis le substrat 1, dans les couches d'oxyde 6 et 9, ce qui a pour effet de neutraliser les charges positives piégées dans ces dernières. C'est ce que représente la figure, sur laquelle un faisceau de radiations 10 frappe la face arrière du substrat 1 cependant qu'une tension 11 est appliquée, avec la polarité indiquée sur la figure pour assurer la conductivité, entre le substrat 1 et la couche métallisée 12; cette dernière relie les sources et les drains et recouvre l'oxyde de porte de tous les dispositifs IGFET. La couche 12, qui est en aluminium ou en un autre métal approprié, fait fonction d'électrode aux fins de l'application de la tension V 11.

Cette tension peut varier entre 5 et 20 volts selon la vitesse de neutralisation désirée et la conductivité du substrat 1. L'objet de l'application de la tension 11 est de diriger les électrons formés dans le cristal vers l'oxyde constituant les portes.

Une source de radiations, par exemple une source de lumière visible ou infrarouge présentant une énergie de photons supérieure à 1,1 électron-volts, permet d'obtenir une quantité suffisante de paires électron-trou.

Les électrons injectés depuis le substrat dans les couches d'oxyde 6 et 9 constituant les portes peuvent être captés par les charges positives présentes dans ces dernières couches, provoquant ainsi leur neutralisation. Une fois les charges neutralisées, le substrat semi-conducteur 1 peut être traité de la façon habituelle et les seules charges positives présentes dans le dispositif final seront celles introduites au cours des étapes de fabrication ultérieures. Toutefois, la formation de la couche métallisée 12 constitue généralement l'une des dernières étapes, si bien qu'il ne reste qu'un très petit nombre d'étapes au cours desquelles des charges positives seraient susceptibles d'être introduites. Le procédé de la présente invention permet d'obtenir des résultats d'autant plus satisfaisants que sa mise en oeuvre est la plus proche de la fin du processus de fabrication.

Il ressort de la figure que le procédé de neutralisation de la présente invention neutralise effectivement les charges à la fois dans les couches minces 6 et 9 et dans les régions plus épaisses 13, 14 et 15, ce qui est avantageux en ce sens que la neutralisation a également pour effet d'augmenter la tension de seuil dans les régions 13 à 15 qui sont ainsi rendues plus isolantes. Si une implantation ionique est employée de façon classique à des fins d'isolement, la dose requise d'ions implantés pourra faire l'objet d'une réduction appréciable. De même, dans le cas d'un isolement par jonction, la tension de claquage des jonctions sera plus importante.

La mise en oeuvre de la présente invention présente une certaine souplesse dans le cas des tranches comportant un grand nombre de dispositifs. Par exemple dans le cas de la technologie à porte en silicium si une métallisation suffisante est appliquée à l'ensemble des dispositifs pour que les électrons puissent être injectés dans l'oxyde depuis les régions comprises entre la source et le drain, la neutralisation sera néanmoins rendue possible par le procédé de la présente invention. Dans le cas où sur une même tranche, il y a un grand nombre de dispositifs, il est souvent difficile d'atteindre chaque électrode de porte, cependant si la majorité d'entre elles sont polarisées, la neutralisation aura lieu.

Il est possible d'introduire un excés de charges négatives, et, de ce fait, de provoquer une surneutralisation. Il faut environ $10^{13}$ électrons injectés/cm$^2$ pour neutraliser 95% des charges introduites dans l'oxyde lors de l'emploi de techniques de fabrication classiques. Pratiquement tant que la concentration des électrons injectés est maintenue à une valeur inférieure à $2 \times 10^{15}$/cm$^2$, il ne se produira aucune surneutralisation important et aucun excés

d'électrons présents. La plage acceptable des concentrations des électrons injectés varie donc entre $1 \times 10^{13}$/cm environ et $2 \times 10^{15}$/cm$^2$ environ.

Dans des techniques de fabrication classiques, on procède souvent à un recuit afin de diminuer les effets des diverses contraintes résultant du procédé. Dans le cas du silicium, on a constaté qu'une étape de recuit d'une durée de 20 minutes à 400°C dans un gaz de formation n'avait aucun effet nuisible sur les électrons piégés dans l'oxyde constituant la porte.

Ainsi, le procédé décrit ci-dessus consiste à irradier au moyen d'un faisceau lumineux la face arrière d'un substrat semi-conducteur monocristallin dans lequel plusieurs dispositifs du type IGFET ont été formés, tout en appliquant une tension appropriée grâce à laquelle les électrons injectés neutralisent les charges positives se trouvant dans l'isolant de porte des dispositifs.

Bien que l'on ait décrit dans ce qui précède et représenté sur le dessin les caractéristiques essentielles de l'invention appliquées à un mode de réalisation préféré de celle-ci, il est évident que l'homme de l'art peut y apporter toutes modifications de forme ou de détail qu'il juge utiles.

**Revendications**

1. Procédé de neutralisation des charges positives contenues dans l'isolant de porte (6; 9) d'au moins un transistor à effet de champ (2; 3) à porte isolée intégré dans un substrat semi-conducteur (1), procédé qui comporte la génération des électrons de conduction dans le substrat par un faisceau de radiations électromagnétiques caractérisé en ce que:

le faisceau de radiations électromagnétiques est appliqué sur la face arrière du substrat (1),

et que les électrons sont injectés depuis le substrat (1) dans l'isolant de porte (6; 9) par application simultanée d'un champ électrique.

2. Procédé selon la revendication 1 caractérisé en ce qu'une alimentation de tension V (11) est connectée entre d'une part une couche métallique (12) uniforme qui constitue l'électrode de porte, et qui vient en contact avec les régions de source (4; 7) et de drain (5; 8) du transistor et d'autre part la face arrière du substrat (1).

3. Procédé selon la revendication 2 caractérisé en ce que le substrat (1) est de conductivité de type p, les régions de source (4; 7) et de drain (5; 8) de conductivité de type n, et que le pôle + de l'alimentation (11) est relié à la couche métallique (12).

4. Procédé selon la revendication 3 caractérisé en ce que la tension V est comprise entre 5 et 20 volts.

5. Procédé selon l'une quelconque des revendications ci-dessus caractérisé en ce que les longueurs d'onde des radiations utilisées, sont comprises entre celles de la lumière visible et celles de l'infrarouge.

6. Procédé selon la revendication 5 caractérisé en ce que l'injection d'électrons dans l'isolant de porte (6; 9) est comprise entre $1 \times 10^{13}$ et $2 \times 20^{15}$ électrons/cm$^2$.

**Patentansprüche**

1. Verfahren zum Neutralisieren von in der Gateisolierung (6; 9) enthaltenen positiven Ladungen von wenigstens einem in einem Halbleitersubstrat (1) integrierten Feldeffekttransistor (2; 3) mit isoliertem Gate, wobei das Verfahren das Erzeugen von Leitelektronen im Substrat durch ein elektromagnetisches Strahlungsbündel einschließt, dadurch gekennzeichnet, daß das elektromagnetische Strahlungsbündel auf die Rückfläche des Substrats gerichtet wird, und daß die Elektronen vom Substrat (1) aus durch gleichzeitiges Anlegen eines elektrischen Feldes in die Gateisolierung (6; 9) injiziert werden.

2. Verfahren nach Anspruch 1, dadurch gekennzeichnet, daß eine Spannungsversorgung V (11) zwischen eine gleichförmige Metallschicht (12), die die Gateelektrode darstellt und die Source- (4; 7) und Draingebiete (5; 8) des Transistors bildet, einerseits, und die Rückseite des Substrats (1) andererseits geschaltet ist.

3. Verfahren nach Anspruch 2, dadurch gekennzeichnet, daß das Substrat (1) p-leitend, die Source (4; 7) und Drainbereiche (5; 8) n-leitend sind, und daß der Pluspol der Versorgung (11) mit der Metallschicht (12) verbunden ist.

4. Verfahren nach Anspruch 3, dadurch gekennzeichnet, daß die Spannung V zwischen 5 und 20 Volt liegt.

5. Verfahren nach einem der obigen Ansprüche, dadurch gekennzeichnet, daß die Wellenlängen der benutzten Strahlungen zwischen denen des sichtbaren Lichtes und denen des infraroten Lichtes liegen.

6. Verfahren nach Anspruch 5, dadurch gekennzeichnet, dass die Menge der in die Gateisolierung (6; 9) injizierten Elektronen zwischen $1 \times 10^{13}$ und $2 \times 20^{15}$ Elektronen/cm$^2$ liegt.

**Claims**

1. Method for neutralizing positive charges contained in the gate insulator (6; 9) of at least one field effect transistor (2; 3) provided with an isolated gate, integrated in a semiconductor substrate (1), said method including the generation of conductive electrons in the substrate by an electromagnetic radiation beam, characterized in that the electromagnetic radiation beam is applied to the backside of the substrate (1), and that the electrons are injected from the substrate (1) into the gate insulator (6; 9) by simultaneously applying an electric field.

2. Method according to claim 1, characterized in that a voltage supply V (11) is connected between a uniform metal layer (12) forming the gate electrode and contacting the source (4; 7) and the drain (5; 8) regions of the transistor on the one hand and the backside of the substrate (1) on the other hand.

3. Method according to claim 2, characterized in that substrate (1) is of conductivity p, the source (4; 7) and the drain (5; 8) regions are of conductivity n, and that the plus pole of supply (11) is connected with metal layer (12).

4. Method according to claim 3, characterized in that the voltage V ranges from 5 to 20 volts.

5. Method according to any one of the above claims, characterized in that the wave lengths of the radiations used are ranging from those of the visible light to those of the infrared light.

6. Method according to claim 5, characterized in that the quantity of electrons injected into the gate insulator (6; 9) is between $1 \times 10^{13}$ and $2 \times 20^{15}$ electrons/cm$^2$.

LUMIERE 10